Europäisches Patentamt

European Patent Office

Office européen des brevets

(19)

(11) Veröffentlichungsnummer : **0 078 339**
**B1**

(12) # EUROPÄISCHE PATENTSCHRIFT

(45) Veröffentlichungstag der Patentschrift :
30.07.86

(21) Anmeldenummer : 81109373.1

(22) Anmeldetag : 30.10.81

(51) Int. Cl.⁴ : **G 01 R  1/073**

(54) **Tastkopfanordnung für Leiterzugüberprüfung mit mindestens einem, eine Vielzahl von federnden Kontakten aufweisenden Tastkopf.**

(43) Veröffentlichungstag der Anmeldung :
11.05.83 Patentblatt 83/19

(45) Bekanntmachung des Hinweises auf die Patenterteilung : 30.07.86 Patentblatt 86/31

(84) Benannte Vertragsstaaten :
DE FR GB IT

(56) Entgegenhaltungen :
FR-A- 2 211 651
US-A- 3 851 161
US-A- 3 906 363
US-A- 4 177 425
IBM TECHNICAL DISCLOSURE BULLETIN, Band 12, No. 10, März 1970 NEW YORK (US) G.A. CACCOMA und A.W. NURCZYNSKI: "AC Probe"; Seite 1667
IBM TECHNICAL DISCLOSURE BULLETIN, Band 19, No. 4, September 1976 NEW YORK (US) P.J. VALLESE: "Subminiature Lands Commining Contact Probe"

(73) Patentinhaber : IBM DEUTSCHLAND GMBH
Pascalstrasse 100
D-7000 Stuttgart 80 (DE)
DE
International Business Machines Corporation
Old Orchard Road
Armonk, N.Y. 10504 (US)
FR GB IT

(72) Erfinder : Asch, Karl
Siedlerstrasse 7
D-7031 Gültstein (DE)
Erfinder : Greschner, Johann, Dr.
Zollernstrasse 14
D-7401 Pliezhausen 2 (DE)
Erfinder : Kallmeyer, Michael
Sperberweg 24
D-7030 Böblingen (DE)
Erfinder : Kulcke, Werner, Dr.
Westerwaldweg 8
D-7030 Böblingen (DE)

(74) Vertreter : Herzog, F. Joachim, Dipl.-Ing ·
Schönaicher Strasse 220
D-7030 Böblingen (DE)

EP 0 078 339 B1

0 078 339

**Beschreibung**

Die Erfindung bezieht sich auf eine Tastkopfanordnung zum Kontaktieren von einer Vielzahl eng beieinanderliegender, schmaler Leiterzüge bzw. Anschlußkontakte und zum Feststellen von Kurzschlüssen und Unterbrechungen, mit mindestens einem eine Vielzahl von federnden Kontakten aufweisenden Tastkopf, wobei die Kontakte des Tastkopfs in Form von einstückigen Fingern gestaltet sind, die Finger (mit ihrer Längsachse) schräg zur Ebene der zu kontaktierenden Leiterzüge auf diese aufsetzbar sind und die Finger maximal so breit wie die Leiterzüge gestaltet sind, linear ausgerichtet, sowie über einen Rücken in Kammform gehalten sind.

Die ständig zunehmenden Schaltgeschwindigkeiten von Rechnern erfordern wegen der Signalverzögerungen immer kürzere Leiterzüge zur Verbindung zwischen den einzelnen Schaltkreisen. Dementsprechend ist die zunehmende Miniaturisierung und Verdichtung der Schaltkreisverbindungen eine natürliche Folge. Halbleiterschaltkreise werden heute auf keramischen Moduln montiert, die aus mehr als 20 Schichten mit mehr als 10 000 Leiterzügen zusammengesintert sind. Die gleiche Entwicklung findet in der nächst höheren Verdrahtungsebene, nämlich bei den sogenannten Karten bzw. Boards statt. Auch diese Karten sind aus mehreren Kunstharzebenen lamelliert, von denen jede etwa 10 000 Leiterzüge aufweisen kann.

Moduln und Karten sind demgemäß sehr kompliziert aufgebaut und weisen nach ihrer Fertigstellung einen beträchtlichen Wert aus. Da die Funktion dieser Komponenten durch einen Fehler in den Leiterzügen in einer Ebene unter Umständen irreparabel zerstört wird, ist es dringend erforderlich, jede Ebene einzeln vor dem Lamellieren zu testen und die lokalisierten, festgestellten Fehler in den Leiterzügen ggf. zu reparieren. Die dabei auftretenden Fehler können Unterbrechungen der Leiterzüge oder Kurzschlüsse zwischen den Leiterzügen sein. Im Prinzip muß jeder Leiterzug gegen jeden anderen getestet werden, was bei 10 000 Leiterzügen zu $0,5 \times 10^8$ Durchgangs- bzw. Isolationstests führt.

Der Testaufwand kann wesentlich reduziert werden, wenn alle, oder wenigstens ein Großteil der Leiterzüge gleichzeitig kontaktiert werden können. Man kann dann nämlich den Isolationstest eines Leiterzuges gegen alle anderen miteinander kurzgeschlossenen Leiterzügen ausführen. In diesem Fall beträgt der Testaufwand beispielsweise nur noch 10 000 Isolationstests und 10 000 Durchgangstests.

Aus dem Stand der Technik ist es beispielsweise aus der deutschen Patentschrift 25 59 004 bekannt, alle Leiterzüge bzw. Anschlußkontakte gleichzeitig zu kontaktieren, um damit die notwendigen Funktionstests durchführen zu können. Gemäß dieser bekannten Anordnung ist eine Vielzahl verschiedener Tastsköpfe mit unterschiedlichen und mit gleichen Tastkontaktmustern bekannt, wobei die Tastköpfe lösbar auf einer Trägerplatte gehalten sind. Die Trägerplatte mit der Kopfkonfiguration wird auf eine große Schaltkarte für den Testzweck abgesenkt. Die Tastköpfe sind über verschiedene Sammelleitungen mit einem Rechner verbunden, um somit die programmierten Testroutinen durchführen zu können. Die Anschlußkontakte der Tastköpfe bestehen aus federnden Kontakten, die senkrecht auf die Anschlußkontakte und Leiterzüge der zu testenden Karte abgesenkt werden. Sie sind aus mehreren Teilen aufgebaut und in einem Muster im Tastkopf angeordnet, der genau dem Leiterzugmuster oder dem Muster der Anschlußkontakte, welches überprüft werden soll, entspricht. Die somit federnd gehaltenen Anschlußkontakte des Tastkopfes sind in ihrem Muster an das zu überprüfende Muster gebunden.

Zur sicheren Kontaktierung einer Vielzahl dicht beieinanderliegender Anschlußstreifen ist es aus der DDR Patentschrift 77 525 bekannt, Federdrähte in einem spitzen Winkel auf die Anschlußstreifen aufzulegen, wobei die Federdrähte durch eine kammartige Führung seitlich geführt sind, damit sie nicht ausweichen können. Auch hier ist wiederum jedem einzelnen Anschlußstreifen ein entsprechender Federdraht positionsgebunden zugeordnet, wobei es sich insgesamt nicht um eine Testanordnung handelt.

In der DE-OS 23 59 149 ist eine Anordnung zur Prüfung elektrischer Kontakte auf Keramiksubstraten, die über gedruckte Leiterzüge miteinander verbunden sind, beschrieben. Die Anordnung enthält ein Kontaktierungsgitter, das aus zwei Leitungsmustern auf einer gedruckten Schaltungskarte besteht, die kammartig sich gegenüberstehend und miteinander verzahnt angeordnet sind. Der Abstand zwischen zwei benachbarten Leitern, die zu jeweils unterschiedlichen kammartigen Leiterzügen gehören, ist kleiner als der Radius des zu kontaktierenden Kontaktes, der eine Stiftform aufweist. Diese kontaktierten Kontakte verbinden dadurch jeweils die beiden Teile des Leiterzugmusters, so daß zwei Zweige einer Brückenschaltung miteinander verbunden sind. Dabei wird über den einen Brückenzweig Strom zum Kontakt geführt und der andere Zweig für die Messung des Widerstandes des zu prüfenden Kontaktes ausgenutzt. Eine Verwendung für das Prüfen und Testen von einer enorm großen Zahl von Leiterzügen und Anschlußkontakten auf Unterbrechungen und Kurzschlüsse ist mit einer derartigen Anordnung nicht möglich.

Aus der US-PS 4 177 425 ist eine Tastkopfanordnung gemäß dem Oberbegriff des Hauptanspruchs bekannt. Beschrieben ist dort eine Tastkopfanordnung zum Kontaktieren von einer Vielzahl eng beieinanderliegender, schmaler Leiterzüge, bzw. Anschlußkontakte und zum Feststellen von Kurzschlüssen und Unterbrechungen, mit mindestens einem eine Vielzahl von defernden Kontakten aufweisenden Tastkopf. Die Kontakte des Tastkopfes sind dabei in Form von einstückigen Fingern gestaltet, die schräg zur Ebene der zu kontaktierenden Leiterzüge auf diese aufsetzbar sind. Die Finger sind maximal so breit wie die Leiterzüge gestaltet und linear ausgerichtet sowie über einen Rücken in Kammform gehalten. Bei dieser bekannten Anordnung sind die Kontaktfinger aus federndem Edelmetall oder einer Edelmetallegierung hergestellt und in Ausnehmungen einer Halterung im Klemmsitz gehalten. Diese Ausnehmungen weisen den Abstand des auf der zu kontaktierenden Schaltung vorhandenen Leiterzugmusters auf. Jedem Leiterzug ist dabei ein einzelner Kontaktfinger zugeordnet. Da wo keine Leiterzüge vorhanden sind, sind auch keine Kontaktfinger in der Halterung eingeklemmt. Über Drähte und Lötverbindungen werden die nicht kontaktierenden Enden der Finger mit der Prüfeinrichtung verbunden. Diese bekannte Anordnung weist positionsgebundene Kontaktfinger auf, die entsprechend der Anordnung der zu kontaktierenden Stellen auf dem zu prüfenden Schaltkreis in die jeweils zugeordneten Ausnehmungen der Halterung eingeklemmt werden müssen. Es ist offensichtlich mühsam und zeitaufwendig jede einzelne Ausnehmung entsprechend der Kontaktierung individualisierend einzusetzen und in der Halterung festzuklemmen. Dadurch ist keine positionsunabhängige Tastkopfanordnung gegeben.

Die Erfindung, wie sie in den Ansprüchen gekennzeichnet ist, löst die Aufgabe, eine Tastkopfanordnung mit einem Tastkopf zu schaffen, bei dem komplizierte, aus vielen Einzelteilen aufgebaute federnde Kontakte vermieden werden, bei dem die starre Bindung an das Leiterzug- bzw. Anschlußkontaktmuster überwunden ist, der die Voraussetzung für ein schnelles Prüfen des Prüflings bildet, und der mit bewährten, beherrschten Technologien relativ einfach herzustellen ist.

Die durch die Erfindung erreichten Vorteile sind im wesentlichen darin zu sehen, daß die Kontakte des Tastkopfs aus einstückigen Fingern besteht, die gegenüber den Leiterzügen nicht positionsgebunden sind, und aus Silicium hergestellt sind. Es ist dabei nicht nötig, die Finger genau auf das Leiterzugmuster auszurichten, eine Führung der Finger erübrigt sich durch das verwendete Material und die Herstellung ist mit Technologien möglich, die erprobt, bewährt und ausgereift sind. Ein wesentlicher Vorteil der erfindungsgemäßen Tastkopfanordnung besteht darin, daß sie die Basis für eine sehr flexible Anordnung zum Prüfen und Testen verschieden gestalteter Testobjekte bildet.

Im folgenden wird die Erfindung anhand der lediglich einen Ausführungsweg darstellenden Zeichnung in Aufbau und Funktionsweise näher erläutert. Darin zeigt :

Figur 1 in perspektivischer und schematischer Darstellung ausschnittsweise die erfindungsgemäße Tastkopfanordnung mit mehreren Tastköpfen über einer zu testenden Karte ;

Figur 2 in Draufsicht einen Ausschnitt eines über einer Karte angeordneten Tastkopfs,

Figur 3 in Seitenansicht einen Tastkopf gemäß der Erfindung über einer Karte,

Figur 4 schematisch in Draufsicht einen Ausschnitt aus einem Tastkopf mit gegenüber der Darstellung in Fig. 1 und 2 anders gestalteten Fingern ;

Figuren 5A bis E schematisch verschiedene Schritte bei der Herstellung des erfindungsgemäßen Tastkopfes teilweise in Seitenansicht und teilweise in Draufsicht ;

Figur 6 schematisch als Blockschaltbild die Architektur eines Testers, der aus einer Vielzahl von Tastköpfen gemäß der erfindungsgemäßen Tastkopfanordnung aufgebaut ist, und

Figur 7 ein Blockschaltbild der in den Tastkopf mitintegrierten Schaltkreise.

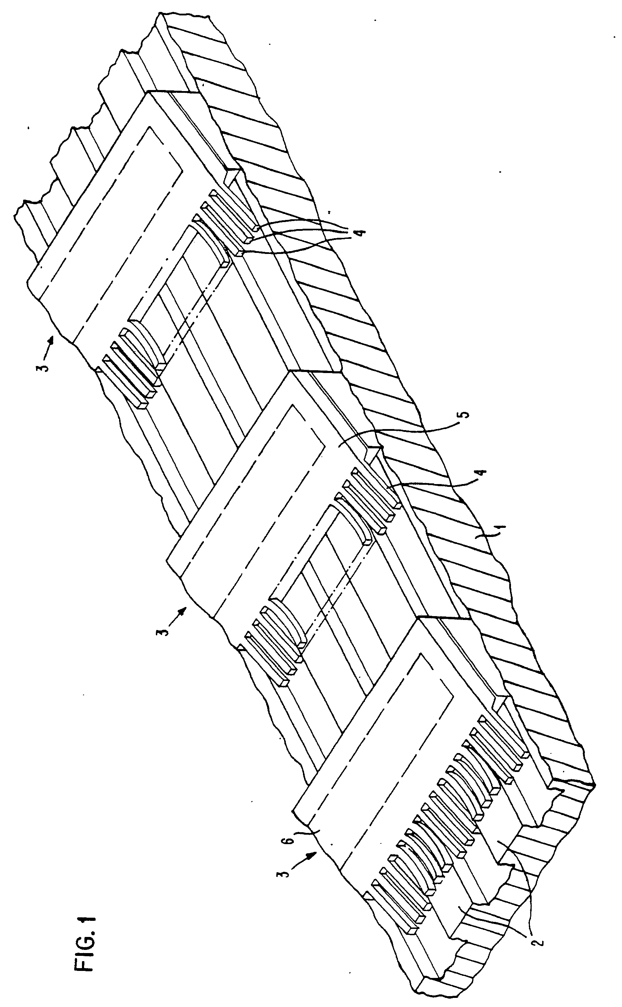

In Fig. 1 ist der Ausschnitt einer zu überprüfenden Karte 1 dargestellt, die mit parallelen Leiterzügen 2 versehen ist. Diese Leiterzüge 2 sind auf Kurzschlüsse zwischen den Leiterzügen bzw. Unterbrechungen der Leiterzüge hin zu überprüfen. Zu dieser Überprüfung sind mehrere Tastköpfe 3 der erfindungsgemäß gestalteten Tastkopfanordnung vorgesehen, die quer zu den Leiterzügen 2 und diese kontaktierend angeordnet sind. Jeder Tastkopf 3 besitzt eine Vielzahl von Fingern 4, die kammförmig mit einem Rücken 5 verbunden sind. In den Rücken 5 können elektrische Schaltkreise 6 mit eingebaut sein, die gestrichelt in der Darstellung der Fig. 1 angedeutet sind.

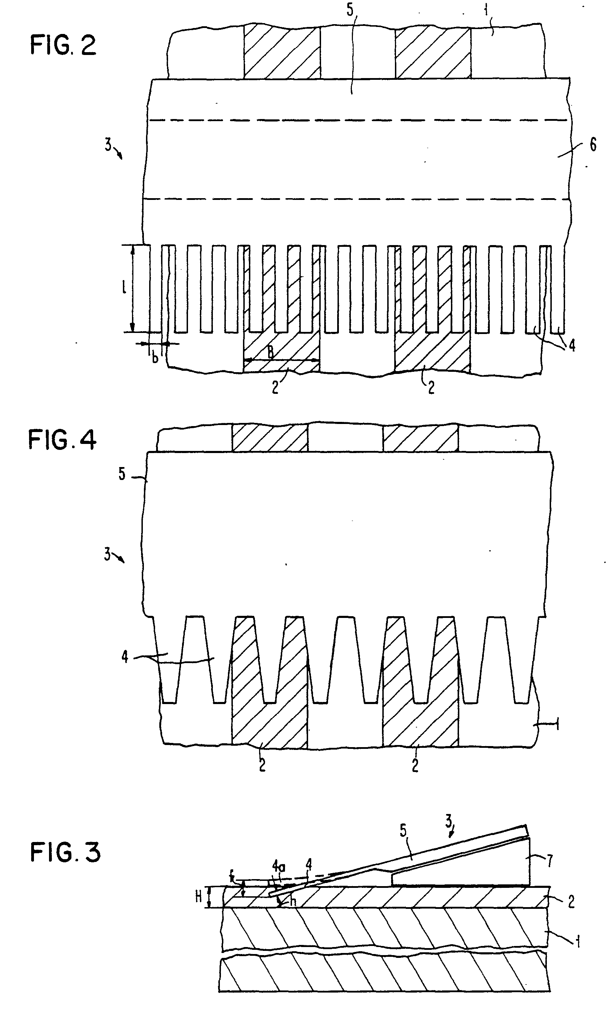

In Fig. 2 ist in Draufsicht ein Ausschnitt aus der zu überprüfenden Karte mit ihren Leiterzügen 2 dargestellt, über denen ebenfalls ausschnittsweise ein Tastkopf 3 mit seinen Fingern 4, dem Rücken 5 und gestrichelt angedeutet den mitintegrierten Schaltkreisen 6 angeordnet ist. In dem dargestellten Beispiel weisen die Finger 4 eine Länge von l und eine Breite von b auf. Die Breite B der Leiter 2 entspricht in diesem Beispiel dem Abstand zwischen zwei Leitern. In dem dargestellten Beispiel ist die Fingerbreite b und der Abstand zwischen zwei benachbarten Fingern gleich gewählt und insgesamt in einer derartigen Größe gestaltet, daß auf eine Leiterzugbreite B in jedem Falle, unabhängig von der Positionierung, immer drei Finger einen Leiterzug kontaktieren und drei Finger im Zwischenraum zwischen zwei Leiterzügen 2 zu liegen kommen.

Wie aus Fig. 1 ersichtlich ist, sind die Leiterzüge 2 erhaben über der Oberfläche der dazwischenliegenden Teile des Karte 1 angeordnet. Dies entspricht der in der Fig. 3 gezeigten Leiterzughöhe H. Diese Fig. 3 zeigt in Seitenansicht die schräge Anordnung eines Tastkopfes 3 gegenüber einem im Schnitt dargestellten Leiterzuges 2 einer zu überprüfenden Karte 1. Dabei ist ein Finger 4 durchgehend und ohne Durchbiegung dargestellt. Dieser Finger 4 entspricht denjenigen Fingern, die gemäß der Fig. 2 zwischen zwei Leiterzüge 2 zu liegen kommen. Der mit 4a gestrichelt dargestellte Finger ist einer von denjenigen, die auf den Leiterzügen 2 zum Aufliegen kommen und durch die aufgewendete Aufdruck- bzw. Andruckkraft durchgebogen werden. Die Durchbiegung beträgt im dargestellten Beispiel f. Die Finger 4 sind mit dem Kamm 5 einstückig ausgeführt und schräg zu der Karte 1 angeordnet. Um diese Schräge eindeutig sicherzustellen und um darüber hinaus die Durchbiegung f nicht über ein höchstzulässiges Maß hinauszutreiben, ist der Tastkopf 3 mit seinem Rücken 5 auf einem Keil 7 angeordnet, dessen

3

Geometrie beim Aufsetzen des Tastkopfes 3 auf die Leiterzüge 2 der Karte 1 sicherstellt, daß die maximale Durchbiegung $f_{MAX}$ nicht überschritten wird. Der Keil 7 ist aus isolierendem Material hergestellt.

Eine typische beispielhäfte Dimensionierung eines solchen aus Silicium gefertigten Tastkopfes 3, wie er in Fig. 2 und 3 dargestellt ist, ergibt nach den Beziehungen einseitig eingespannter Balken, die an ihrer Spitze mit einer Kraft F bzw. einem Kontaktdruck $P = F/b^2$ beaufschlagt werden, für die Durchbiegung f an dem freien, äußersten Ende des Fingers 4 :

$$f = 4 \frac{1}{E} \frac{l^3}{h^3} bP$$

und für die maximale Durchbiegung

$$f_{max} = \frac{2}{3} \frac{l^2}{h} \frac{k_B}{E}$$

Darin sind :

f die Durchbiegung des äußersten Fingerendes,
l die Länge der Finger,
b die Breite der Finger,
h die Dicke der Finger,
F die am äußersten Fingerende angreifende Kraft,
$P = F/b^2$ der Kontaktdruck auf den Leiterzug
E der Elastizitätsmodul
$k_B$ die zulässige Biegespannung,
$f_{MAX}$ die maximale Durchbiegung vor Bruch.

Zur Sicherheit sollte f immer $\leq 1/3\ f_{MAX}$ bleiben.

Unter den Voraussetzungen :

| | |
|---|---|
| Leiterzugbreite B | 60 μm |
| Fingerbreite b | 10 μm |
| Fingerdicke h | 10 μm |
| Leiterzughöhe H | 50 μm |
| = Durchbiegung f der den Leiterzug kontaktierenden Finger | |
| Kontaktdruck P der Finger auf dem Leiterzug | 10 N/cm² |
| zwischen den Leiterzügen | 0 N/cm² |
| E-Modul Silicium | $1.7 \times 10^7$ N/cm² |
| zulässige Biegespannung $k_B$ | $3 \times 10^4$ N/cm² |

ergibt sich eine Fingerlänge 1 = 1,3 mm.

Die maximale Durchbiegung vor· Bruch errechnet sich zu $f_{MAX} = 200$ μm und ist mehr als dreimal größer als die Leiterzughöhe H.

In Fig. 4 ist der Ausschnitt eines Tastkopfes 3 über dem Ausschnitt einer Karte 1 dargestellt. Dieser Tastkopf 3 weist Finger 4 auf, die vom Rücken 5 zur Fingerspitze hin in ihrer Breite verjüngend gestaltete Finger 4 aufweist. Darüber hinaus unterscheidet sich der in Fig. 4 dargestellte Tastkopf 3 von dem in den Fign. 2 und 3 dadurch, daß der Abstand der Fingerspitzen im Verhältnis zu den Leiterzügen 2 ein anderer ist. In dem in Fig. 4 dargestellten Beispiel kontaktiert jeweils nur ein Finger 4 einen darunter liegenden Leiterzug 2. Die Vergrößerung der Breite der Finger 4 von der Spitze zum Kamm 5 hin erhöht die Bruchfestigkeit bei konstantem Kontaktdruck, verglichen mit der Anordnung gemäß Fign. 2 und 3.

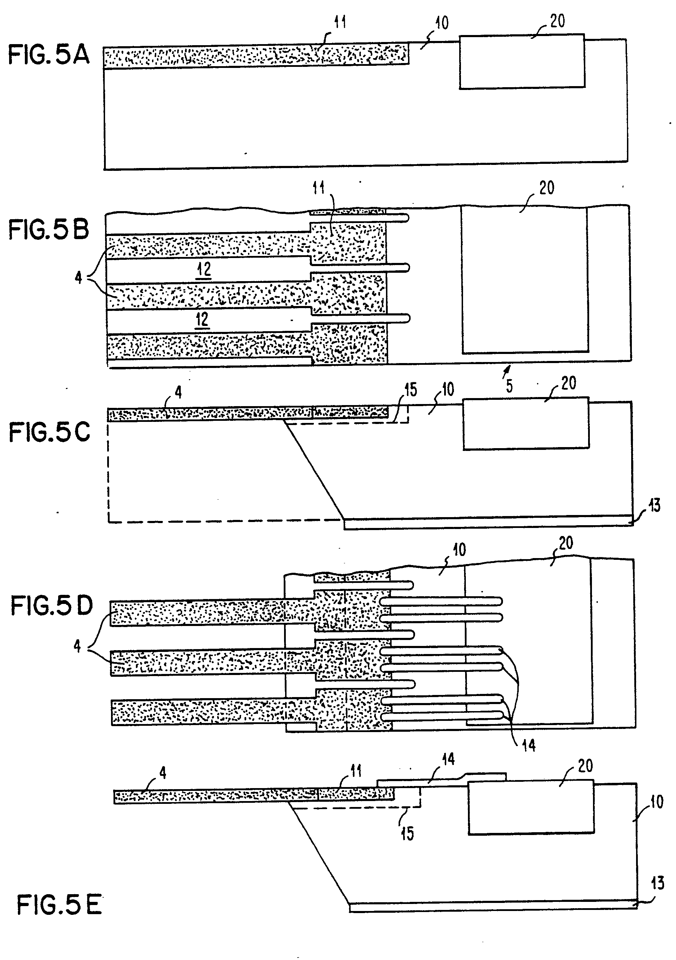

Die Herstellung des erfindungsgemäßen Tastkopfes mit seiner Vielzahl von Fingern in der geforderten und notwendigen feinen Dimension erfolgt zweckmäßigerweise unter Anwendung mikromechanischer Siliciumtechniken, wie sie überblicherwxeise im wesentlichen nachstehend anhand der Fig. 5 beschrieben sind. In ein Siliciumsubstrat 10, das der nötigen Länge des Tastkopfes 3 entspricht, wird zunächst die Ansteuerlogik 20 eingebracht. Diese Ansteuerlogik 20 wird nachfolgend noch näher erläutert werden. Ihre Herstellung und Einbringung in das Siliciumsubstrat 10 erfolgt nach bekannten Verfahren der integrierten Schaltkreistechniken. Die Ansteuerlogik 20 erstreckt sich zweckmäßigerweise in Längsrichtung des Kammes 5 über die gesamte Länge des Tastkopfes, damit eine leitungsmäßige Kontaktierung mit den Fingern 4 einfach zu bewerkstelligen ist.

Durch die Verwendung von Siliciumwafern handelsüblicher Größen, die heute bereits bei mehr als 10 cm Größe liegen, können Tastköpfe hergestellt werden, deren Länge 10 cm und mehr, entsprechend des Größe des Ausgangswafers, betragen.

Nachdem in das Siliciumsubstrat 10 die Ansteuerlogik 20 eingebracht ist, wird eine mit etwa $10^{20}$ Boratomen/cm³ hochdotierte Schicht 11 im Bereich der Finger 4 und ihrer Ansatzbereiche 4' im Kammbereich 5 erzeugt, die tiefenmäßig die spätere Dicke h der Finger 4 μm einige μm überschreitet. Diese Schicht 11 ist in Fig. 5A im Querschnitt dargestellt.

Nach photolithographischer Strukturierung werden, wobei eine $SiO_2$-Schicht als Zwischenmaske verwendet wird, aus der mit Bor hochdotierten Schicht 11 die Zwischenräume 12 zwischen den Fingern 4 herausgeätzt. Gleichzeitig werden die Zwischenräume 12 bis über die bordotierte Schicht 11 tiefenmäßig hinaus bis in das undotierte Material des Siliciumsubstrats 10 hin unterbrochen. Diese Strukturierung erfolgt durch anisotropes reaktives Ionenätzen in $Ar/Cl_2$-Atmosphäre. Das Ergebnis ist in der in Fig. 5B gezeigten Aufsicht dargestellt.

Anschließend wird die Rückseite bzw. Unterseite des Siliciumsubstrats 10 mit einer $SiO_2$-Schicht 13 abgedeckt und danach das freie, undotierte Silicium bis auf die hochdotierte Borschicht 11, d. h. bis auf die Finger 4 abgeätzt, wie dies der Fig. 5C zu entnehmen ist. Dieses Ätzen erfolgt durch anisotropes, preferentielles Naßätzen mit Äthylendiamin, Brenzcatechin und Wasser. Die Draufsicht in Fig. 5D zeigt das Ergebnis mit den fertigen Fingern 4 und den etwas verbreiterten Anschlußkontaktbereichen. Diese Figur zeigt darüber hinaus jeweils zwei Leiterzüge 14 zu einem Finger 4, durch den der Finger mit den Schaltungen der Ansteuerlogik 20 verbunden wird. In Querschnittansicht ist der fertige Tastkopfkamm in der Fig. 5E dargestellt. Dabei stellt die strichpunktierte Linie 15, die auch in Fig. 5C dargestellt ist, den Bereich dar, der von der hochdotierten Borschicht 11 noch übriggeblieben ist.

Durch die hohe Bordotierung des Siliciums in den Bereichen 11 sind die elektrischen Widerstände der Finger 4 sehr gering. Bei einer Bordotierung von $10^{20}$ Atomen/cm$^3$ hat das Silicium einen spezifischen Widerstand von nur $\rho \simeq 10^{-3}$ Ohm·cm. Für die oben angegebenen Dimensionen der Finger $1 = 1,3$ mm, $b = 10$ μm, $h = 10$ μm ergibt sich daraus ein Längswiderstand von etwa 0,01 Ohm. Dieser Widerstand ist klein genug für die Anwendung. Es braucht deshalb aus Leitfähigkeitsgründen auf die Finger kein zusätzlicher metallischer Belag aufgebracht zu werden. Aus Gründen der Elastizität kann jedoch ein metallischer Belag unter Umständen günstig sein.

Für den elektrischen Test einer Karte mit einer Vielzahl von Leiterzügen bzw. Anschlußkontakten werden in Richtung der Leiterzüge mehrere Tastköpfe 3 vorgesehen, wie dies in Fig. 1 angedeutet ist. Die Leiterzüge werden über die einzelnen Tastköpfe 3 kontaktiert und auf Durchgang bzw. Unterbrechung zu anderen Leiterzügen getestet. Zu diesem Zweck sind die Tastköpfe entlang einer Bahn angeordnet, deren breite der Länge der Kämme, beispielsweise 10 cm, entspricht. Der Abstand zwischen den einzelnen Tastköpfen 3 entspricht der kürzesten dazwischen vorkommenden Leiterzuglänge bzw. der maximalen Länge, auf welcher ein Fehler festgestellt werden soll. Ist die zu testende Karte 1 breiter als es der Länge der Tastköpfe 3 entspricht, so können mehrere Kämme direkt oder versetzt nebeneinander die Breite der Karte abdecken.

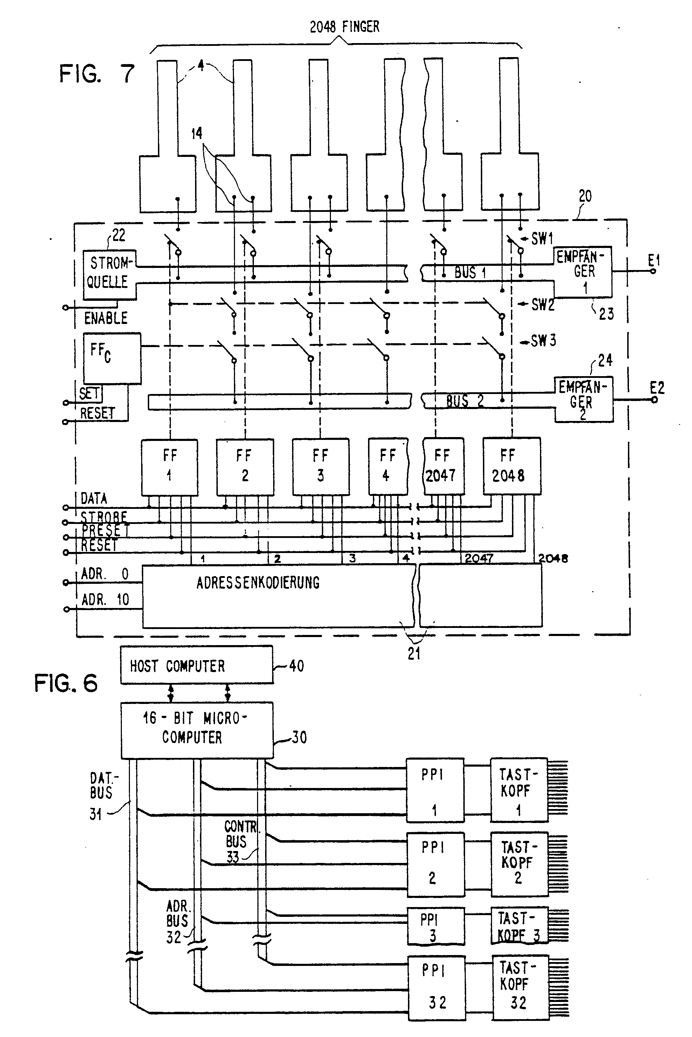

Anhand des in der Fig. 6 dargestellten Beispieles der Architektur eines Testers, werden anschließend elektrische Testroutinen und die zu deren Ausführung erforderliche Ansteuerlogik näher beschrieben.

Die in Fig. 6 schematisch gezeigte Architektur eines Testers enthält beispielsweise 32 Tastköpfe 1 bis 32 mit je 2 048 Fingern und integrierter Ansteuerlogik. Weiterhin enthält der Tester einen 16-Bit-Mikrocomputer 30, der mit einem Host-Computer 40 verbunden ist. Jeder Tastkopf ist über ein zugeordnetes programmierbares peripheres Interface PPI 1 bis 32 an einen Datenbus 31, einen Adreßbus 32 und einen Controlbus 33 angeschlossen. Die programmierbaren peripheren Interfaces haben die Aufgabe, die Daten-, Adreß- und Steuerleitungen jedes einzelnen Tastkopfes jeweils an den Mikrocomputer 30 zu adaptieren.

Anhand der in Fig. 7 schematisch dargestellten integrierten Tasterlogik für einen Tastkopf werden nachfolgend die einzelnen Daten-, Adreß- und Steuerleitungen sowie die funktionellen Zusammenhänge erläutert. Die in den Rücken 5 jedes kamms mitintegrierte Schaltkreislogik 20 ist gestrichelt dargestellt und steht über Leitungen 14 mit den einzelnen Zinken in Verbindung. Die Schaltkreislogik 20 enthält die Adreßdecodierung 21, die 11 Adreßleitungen ADR Ø bis ADR 10 auf der Eingangsseite und 2 048 Steuerleitungen 1 bis 2 048 auf der Ausgangsseite aufweist. Diese Ausgangsleitungen sind jeweils einer einem einzelnen Finger 4 zugeordneten Speicherzelle $FF_1$ bis $FF_{2048}$ zugeordnet. Die einzelnen Speicherzellen $FF_N$ werden weiterhin eingangsseitig von einer Leitung DATA angesteuert, die allen gemeinsam ist. Eine logische « 1 » auf dieser Datenleitung setzt eine adressierte Speicherzelle $FF_N$ mit der negativen Flanke eines Strobe-Pulses. Eine logische « Ø » auf dieser Datenleitung setzt die adressierte Speicherzelle mit der negativen Flanke des Strobe-Impulses zurück. Um dieses Erfüllen zu können, ist eine weitere Leitung « STROBE » vorgesehen, die allen Speicherzellen eingangsseitig zugeführt ist. Damit werden Daten auf der Datenleitung in eine adressierte Speicherzelle eingeschrieben. Eine weitere Leitung « PRESET » ist zum gemeinsamen Setzen aller Speicherzellen $FF_1$ bid $FF_{2048}$ vorgesehen. Über eine Leitung « RESET » können alle Speicherzellen gemeinsam zurückgesetzt werden. Die integrierte Schaltkreislogik 20 enthält weiterhin eine allen Fingern gemeinsame Speicherzelle $FF_C$, die über eine SET-Leitung gesetzt und über eine RESET-Leitung zurückgesetzt wird. Weiterhin ist eine Stromquelle 22 vorgesehen, die über eine ENABLE-Leitung gesteuert ein- bzw. ausgeschaltet wird. Die Stromquelle 22 ist über eine gemeinsame Sammelleitung BUS1 entweder direkt oder über bestimmte Finger mit einem ersten Empfänger 23 verbunden, an dessen anderer Seite die Ausgangsleitung E1 sich befindet. Eine zweite Sammelleitung BUS2 ist mit einem zweiten Empfänger 24 verbunden, auf dessen Ausgangsseite der Ausgang E2 sich befindet. Jedem einzelnen Finger 4 sind jeweils drei Schalter SW1, SW2 und SW3 zugeordnet. Diese Schalter können MOS-Schalter sein. Die Schalter SW1, SW2 und SW3 werden von den wahlfrei adressierbaren Speicherzellen $FF_1$ bis $FF_{2048}$ bzw. von der gemeinsamen Speicherzelle $FF_C$ gesteuert. Dabei wird der Schalter SW1n des Fingers n immer zusammen mit dem Schalter SW2 des Fingers n + 1 geschaltet. Über den Schalter SW1 wird ein Finger mit den gemeinsamen Quellen/Empfänger-BUS1 verbunden. Dies geschieht für die noch zu beschreibenden Tests « Finde Leiterzug », « Kurzschluß » und « Unterbrechung ». Über die Schalter SW2 und SW3 werden die zugeordneten Finger mit den Empfänger-BUS2 verbunden, was für den Test « Finde Leiterzug » geschieht. Dabei können die Schalter SW3 alle nur gemeinsam betätigt werden. Die Betätigung der Schalter SW1 und SW2 ist entweder über die wahlfreie Adressierung von den einzelnen Speicherzellen $FF_1$ bis $FF_{2048}$ möglich oder über deren gemeinsame Eingangsleitung PRESET. Mit Hilfe eines Signals auf der Leitung RESET werden die Schalter SW1 und SW2 alle gemeinsam gleichzeitig über deren Speicherzellen geöffnet.

Abgesehen von den eigentlichen Versorgungsleitungen für die Stromquelle 22 benötigt demnach die Schaltkreislogik 20 für den Tastkopf im dargestellten Beispiel nur 20 Anschlußleitungen bei 2 048 adressierbaren Fingern.

Es werden nun im folgenden die verschiedenen Tests beschrieben. Zunächst der Test « Finde Leiterzug » und der « Funktionstest ».

Im Test « Finde Leiterzug » werden die Adressen der einzelnen Finger, die auf einem gemeinsamen Leiterzug liegen, identifiziert. Dazu werden mit Hilfe der gemeinsamen Speicherzelle $FF_C$ alle Schalter SW3 geschlossen. Dazu erscheint ein Signal auf der Eingangsleitung SET. Anschließend wird der Schalter $SW1_n$ und somit auch der Schalter $SW2_{n+1}$ über die Adressierung der Speicherzelle $FF_1$ geschlossen, womit der Finger 1 mit dem BUS1 und der Finger 2 mit dem BUS2, bzw. allgemein der Finger n mit dem BUS1 und der Finger n + 1 mit dem BUS2 verbunden wird. Anschließend wird die Stromquelle 22 durch ein Signal auf der Leitung ENABLE aktiviert.

Sind die Finger n und n + 1 auf einem gemeinsamen Leiterzug, so wird ein Signal vom Empfänger 24 empfangen. Ist dies nicht der Fall, erreicht den Empfänger 24 kein Signal.

Dieser Test wird mit n = 1 bis n = 2 047 durchgeführt.

Der Test « Funktionstest » wird benutzt, um die integrierte Schaltkreislogik 20 eines Tastkopfes 3 zu überprüfen. Dieser Test läuft wie der Test « Finde Leiterzug » ab, ohne jedoch den Tastkopf selbst auf ein Testobjekt aufzubringen.

Wird bei diesem Test irgendwann über den BUS2 am zweiten Empfänger 24 ein Signal empfangen, so haben die adressierten Finger miteinander Kurzschluß.

Der erste Empfänger 23 kann mittels der Sammelleitung BUS1 zum Testen der Stromquelle 22 benutzt werden. Dabei kommen die empfangenen Signale entweder von der eigenen Stromquelle oder sie kommen von der Stromquelle eines anderen Tastskopfes über dazwischenliegende Leiterzüge.

Der Test « Unterbrechung » dient zur Feststellung der ungestörten Verbindung eines Leiterzuges vom Leiteranfang bis zum Leiterende.

Dazu werden mit Hilfe der gemeinsamen Speicherzelle $FF_C$ mittels des Signals RESET auf der entsprechenden Leitung alle Schalter SW3 geöffnet. Danach wird der Schalter SW1 desjenigen Fingers des Tastkopfes geschlossen, der am Anfang des betreffenden Leiterzuges angeordnet ist. Dadurch wird dieser Finger oder werden diese Finger mit dem BUS1 verbunden. Anschließend wird derjenige Schalter SW1 des Fingers bzw. der Finger desjenigen Tastkopfes geschlossen, der am Ende des zugehörigen Leiterzuges angeordnet ist. Damit sind dann wieder die entsprechenden Finger mit dem entsprechenden Empfänger BUS1 verbunden. Anschließend wird die Stromquelle 22 desjenigen Tastkopfes, der am Anfang des Leiterzuges ist, aktiviert. Ist der Leiterzug nicht unterbrochen, so wird am ersten Empfänger 23 desjenigen Tastkopfes, der dem Leiterzugende zugeordnet ist, ein Signal empfangen, andernfalls nicht.

Die Daten derjenigen Finger und Tastköpfe, die einem Leiterzuganfang zugeordnet ist, werden durch die entsprechenden Daten der zugehörigen zu überprüfenden Karte vom Host-Computer 40 und durch diejenigen Daten, die beim vorhergehenden Test « Finde Leiterzug » festgestellt worden sind, erzeugt. Die Daten für die Leiterzugenden sind aus den Daten der Testobjekte durch den Host-Computer 40 erzeugt worden.

Im Test « Kurzschluß » soll festgestellt werden, ob einer der zu testenden Leiterzüge mit einem anderen bzw. keinem anderen Kontakt hat.

Dazu werden alle Schalter SW3 durch ein Signal auf der Leitung RESET mittels der gemeinsamen Speicherzelle $FF_C$ geöffnet. Anschließend wird derjenige Schalter SW1 des Fingers n desjenigen Tastkopfes geschlossen, der am Beginn des Leiterzuges angeordnet ist, wodurch dieser mit der entsprechenden Stromquelle 22 über den BUS1 verbunden ist. Danach werden sämtliche Schalter SW1 und SW2 des nächsten Tastkopfes, der über der zugehörigen Leiterbahn ist, geschlossen und nur diejenigen Schalter SW1 und SW2 geöffnet, deren Finger auf dem zu testenden Leiterzug liegen. Danach wird diejenige Stromquelle 22 desjenigen Tastkopfes aktiviert, der am Anfang des betreffenden Leiterzuges angeordnet ist.

Besteht irgendeine Verbindung zu den anderen Leiterzügen, die unter den zugehörigen Tastköpfen liegen, so wird ein Signal am ersten Empfänger 23 des zweiten Tastkopfes empfangen, anderenfalls nicht.

Dieser Test ist mit all den Tastköpfen durchzuführen, die über einem zu testenden Leiterzug angeordnet sind.

Das Datenformat für die Daten des Host-Computers 40 ist so strukturiert, daß der Mikrocomputer 30

0 078 339

die Daten derjenigen Leiterzüge eines Segments der zu untersuchenden Karte von dem Host-Computer 40 erhält und dieser speichert.

Dabei werden pro Tastkopf 2 049 Doppelworte zum Mikrocomputer 30 übertragen. Sie bilden einen Datenblock.

Die Daten pro Finger betragen 32 Bits und sind wie folgt strukturiert :

Bit 0 bis 15 enthalten Daten, die aufgeteilt sind in Tastkopfadresse in den Bits 0 bis 4 und Fingeradresse in den Bits 5 bis 15. Die Bits 16 bis 31 enthalten die Leiterzugendadresse, wiederum aufgeteilt in Tastkopf- und Fingeradresse.

Sind die Daten in den Bits 0 bis 15 und in den Bits 16 bis 32 ungleich 0, so bedeutet dies, daß der Leiterzug unter diesem Tastkopf beginnt und bei der angegebenen Leiterzugendadresse endet. Sind nur in den Bits 0 bis 15 die Daten ungleich 0, so bedeutet dies, daß der Leiterzug an einem Tastkopf mit niederer Adresse beginnt und an diesem Tastkopf nicht endet.

Direkt vom Host-Computer werden nur die Daten in den Bits 0 bis 4 bzw. 16 bis 20 übertragen, wobei die eigene Tastkopfadresse redundant ist, da sie durch den Datenblock bereits gegeben ist.

Die Daten in den Bits 0 bis 4 sind 0, wenn kein Leiterzug unter dem entsprechenden Finger erwartet wird.

Die Daten sind ungleich 0 und stellen die nächste Tastkopfadresse dar, die sich über demselben Leiterzug befindet. Diese Information ist notwendig für den Kurzschlußtest.

Stellen die Daten in den Bits 0 bis 4 die eigene Tastkopfadresse dar, so endet der Leiterzug hier.

Die Daten der Bis 15 bis 20 stellen die Tastkopfadresse dar, bei welcher ein Leiterzug endet. Sie werden zusammen mit dem Inhalt der Bits 27 bis 31 beim Unterbrechungstest verwendet.

Die Bits 5 bis 15, die die Fingeradresse darstellen, werden bei dem Test « Finde Leiterzug » bzw. bei dem anschließenden Korrelationstest erzeugt und vom Mikrocomputer eingesetzt.

Die Bits 21 bis 31, Fingeradresse oder Leiterzugnummer, werden gleichfalls nach dem Korrelationstest vom Mikrocomputer übertragen, wenn die Bits 16 bis 20 der Daten des Hostcomputers unter der entsprechenden Fingeradresse gleich 0 sind.

Pro Datenblock wird ein Doppelwort übertragen, das in den Bits 0 bis 15 die Zahl der erwarteten Leiterzüge unter dem Tastkopf, in den Bits 16 bis 31 die Anzahl der Leiterzuganfänge unter dem Tastkopf, enthält.

Nach Ablauf der Tests « Finde Leiterzug » und « Korrelation » sind die Datenblocks vervollständigt und die Daten pro Finger können folgendermaßen benützt werden :

Sind die Bits 5 bis 15 ungleich 0, bedeutet dies, daß hier ein Leiterzug unter dem Finger gefunden wurde, die Daten stellen die Fingeradresse dar. Sind die Bits 0 bis 4 gleichfalls ungleich 0 und stellen sie nicht die eigene Tastkopfadresse dar, so ist dieser Leiterzug bei dem entsprechenden Tastkopf bei gleicher Fingeradresse oder gleicher Leiterzugnummer wieder zu finden. Entsprechen die Daten der eigenen Tastkopfadresse, so endet der Leiterzug hier. Sind die Bits 16 bis 20 ebenfalls ungleich 0, so beginnt der Leiterzug unter dem gerade bearbeiteten Tastkopf und endet bei demjenigen Tastkopf, dessen Adresse durch den Inhalt der Bits 16 bis 20 definiert ist. Sind die Bits 0 bis 4 gleich 0, so wurde zwar ein Leiterzug unter dem Finger gefunden, aber nicht erwartet. Sind die Bits 5 bis 15 gleich 0, so bedeutet dies, daß kein Leiterzug unter dem Zinken gefunden wurde. Sind die Bits 0 bis 4 ebenfalls 0, so wurde auch kein Leiterzug unter diesem Finger erwartet. Sie die Bits 0 bis 4 ungleich 0, so wurde zwar ein Leiterzug unter diesem Finger erwartet, aber nicht gefunden.

Der Mikrocomputer 30 erzeugt Leiterzugdaten während des Tests « Finde Leiterzug » und speichert diese getrennt von den Daten des Host-Computers. Die Datenbreite beträgt 8 Bit pro Finger.

Steht in einem Datenbyte 0, so bedeutet dies, daß kein Leiterzug unter dem Finger gefunden wurde. Daten ungleich 0 bedeuten, ein Leiterzug wurde unter dem Finger gefunden. Die Leiterzugdatenadresse ist identisch mit der jeweiligen Fingeradresse.

Der Leiterzug Datenspeicher ist nur 2 049 Byte groß und wird nach den Tests « Finde Leiterzug » und « Korrelation » pro Tastkopf durch die Leiterzugdaten des nächsten Tastkopfes im Mikrocomputer 30 überschrieben.

Die Speichergröße beträgt für die Daten des Host-Computers 4 kword/Tastkopf = 128 kword/Segment. Für den Mikrocomputer beträgt dies 2 kbyte = 1 kword/Segment, wobei ein Word = 16 Bits enthält.

Die Mikrocomputerdaten werden beim Test « Finde Leiterzug », beginnend bei Tastkopf 1, wie vorstehend beschrieben, erzeugt. Die Anzahl der gefundenen Leiterzüge entsteht dabei durch die Summation der Übergänge von 0 auf 1.

Beim Korrelationstest wird die Anzahl der gefundenen Leiterzüge mit der Anzahl der erwarteten Leiterzüge, die durch die Daten des Host-Computers 40 gegeben sind, verglichen. Wird Ungleichheit festgestellt, so erfolgt eine Fehlermeldung. Bei Gleichheit der gefundenen und erwarteten Leiterzüge wird ein Korrelationslauf durchgeführt, um die Verschiebung des gefundenen Leiterzugmusters gegenüber dem vom Host-Computer vorgegebenen, zu minimisieren.

Danach werden bei ausreichender Korrelation die Finderadressen der leiterzugdaten gleich 0 im Mikrocomputer in die entsprechenden Bits 5 bis 15 und 20 bis 31 der Host-Computerdaten übertragen.

Beim Unterbrechungstest werden die Daten des Host-Computers, beginnend bei Tastkopf 1, Finger 1 auf Leiterzug-Anfangsdaten 0 und Tastkopf- sowie Fingeradresse ebenfalls 0, abgefragt. Im zugehörigen

7

Feld für das Leiterzugende ist dann die Adresse desjenigen Tastkopfes und Fingers zu finden, bei dem sich das Leiterzugende befindet.

Beim Kurzschlußtest werden die Leiterzug-Anfangsdaten wiederum auf 0 abgefragt. Die Daten im Feld für die Tastkopfadresse, d. h. die Bits 0 bis 4, enthalten dann die Adresse des nächsten Tastkopfes, der über demselben Leiterzug angeordnet ist. Anschließend wird wie beim Test auf Unterbrechung, verfahren.

Für die verschiedenen Tests ergeben sich bei einer Mikrosekunde durchschnittlicher Instruktionszeit und 32 Tastköpfen/Segment folgende Testzeiten

« Finde Leiterzüge »
ca. 7 Befehle/Finger  = 400 000 µsec/Segmente
$= 7 \times 2048 \times 32 \times 1$  = 400 msec/Segment
« Korrelationstest »
ca. 10 Statements/Finger  = 660 000 µsec/Segment
$= 10 \times 2048 \times 32 \times 1$  660 msec/Segment
« Unterbrechungstest »
ca. 20 Statements/Finger  20 000 µsec/Segment
$= 20 \times 1000 \times 1$  20 msec/Segment
« Kurzschlußtest »
(1000 Leiterzüge/Segment — mittlere Leiterzuglänge = 10 Pos)
ca. 10 × Unterbrechungstest  = 200 msec/Segment

1 340 msec/Segment

Diese Testzeiten zeigen, daß aufgrund der Erfindung der zeitliche Aufwand für den Test einer sehr großen und komplexen Karte auf ein in sehr vernünftigen Rahmen liegendes Maß begrenzt werden kann.

**Patentansprüche**

1. Tastkopfanordnung zum Kontaktieren von einer Vielzahl eng beieinanderliegender, schmaler Leiterzüge (2) bzw. Anschlußkontakte und zum Feststellen von Kurzschlüssen und Unterbrechungen mit mindestens einem eine Vielzahl von federnden Kontakten (4) aufweisenden Tastkopf (3), wobei die Kontakte des Tastkopfs (3) in Form von einstückigen Fingern (4) gestaltet sind, die Finger (mit ihrer Längsachse) schräg zur Ebene der zu kontaktierenden Leiterzüge (2) auf diese aufsetzbar sind, und die Finger maximal so breit wie die Leiterzüge gestaltet und linear ausgerichtet sowie über einen Rücken (5) in Kammform gehalten sind, dadurch gekennzeichnet, daß

a) die Finger gegenüber den Leiterzügen ohne stasse Zuordnung angeordnet sind

b) die Finger und der Rücken aus Silicium bestehen und

c) der aus Fingern und Rücken bestehende Kamm einstückig in Halbleitertechnologie hergestellt ist.

2. Tastkopfanordnung nach Anspruch 1, dadurch gekennzeichnet, daß elektronische Schaltkreise (6, 20), insbesondere zur Signalverstärkung und Adreßierung dienende logische und decodierende Schaltkreise, im Tastkopf (3) bzw. Rücken (5) desselben mitintegriert sind.

3. Tastkopfanordnung nach einem der vorigen Ansprüche, dadurch gekennzeichnet, daß die Breite (b) der Finger (4) und ihr gegenseitiger Abstand im Kontaktbereich mit den Leiterzügen (2) so gewählt ist, daß auf einem Leiterzug (2) gleichzeitig mehrere Finger aufliegen.

4. Tastkopfanordnung nach einem der vorigen Ansprüche, dadurch gekennzeichnet, daß die Finger (4) rechteckigen oder zum Rücken (5) hin zunehmenden Querschnitt aufweisen.

5. Tastkopfanordnung nach einem der vorigen Ansprüche, dadurch gekennzeichnet, daß die Finger (4) mit einem metallischen Überzug versehen sind.

6. Tastkopfanordnung nach Anspruch 1 oder einem der Ansprüche 2 bis 5, dadurch gekennzeichnet, daß eine Selbstüberprüfung auf Fehler in den Fingern, insbesondere Kurzschlüsse zwischen benachbarten Fingern, bzw. auf Kontaktschluß mit dem zu kontaktierenden Leiterzug durchführbar ist.

7. Tastkopfanordnung gemäß einem der vorigen Ansprüche, dadurch gekennzeichnet, daß mehrere Tastköpfe entsprechend dem Kontaktmuster in einer Reihe hintereinander in einem derartigen Abstand voneinander angeordnet sind, welcher dem kürzesten vorkommenden Leiterzug bzw. dem Abstand der Anschlußkontakte oder der maximalen Länge, auf welche Fehler zu lokalisieren sind, entspricht.

8. Tastkopfanordnung nach einem der vorigen Ansprüche, dadurch gekennzeichnet, daß zum Aufbau eines Testers ein oder mehrere Tastköpfe (1-32) über je ein programmierbares, peripheres Interface ($PPI_1$-$PPI_{32}$) an Daten- (31), Adreß- (32) und Steuer- (33) Sammelleitungen eines Mikrocomputers (30) angeschlossen sind, der seinerseits mit einem Rechner (Host-Computer 40) zum Durchführen und Protokollieren verschiedener Prüfungen verbindbar ist.

9. Tastkopfanordnung nach Anspruch 7 oder 8, dadurch gekennzeichnet, daß zu Beginn jedes Tests eine Zuordnung zwischen den Fingern (4) und von ihnen kontaktierten Leiterzügen (2) (« Finde Leiterzug ») mit Adressenfestlegung vorgenommen wird.

**0 078 339**

10. Tastkopfanordnung nach einem der vorigen Ansprüche, dadurch gekennzeichnet, daß als Silicium monokristallines Silicium verwendet wird.

**Claims**

1. Probe head arrangement for contacting a plurality of closely adjacent, narrow conductor lines (2) or contact pads, respectively, and for determining shorts and interruptions with at least one probe head (3) comprising a multitude of resilient contacts (4), the contacts of the probe head (3) being designed in the form of one-piece fingers (4), the fingers being placeable (with their longitudinal axis) obliquely to the plane of the conductor lines (2) to be contacted, and corresponding in their maximum width to the design of the conductor lines and being linearly aligned and provided through a back (5) in comb-form, characterized in that
   a) the fingers are without a fixed correlation to the conductor lines
   b) the fingers and the back consist of silicon, and
   c) the comb consisting of fingers and back is made in one piece in semiconductor technology.

2. Probe head arrangement as claimed in claim 1, characterized in that electronic circuits (6, 20), particularly logic and decoding circuits for signal amplification and addressing, are also integrated in the probe head (3) and its back (5), respectively.

3. Probe head arrangement as claimed in any one of the preceding claims, characterized in that the width (b) of the finger (4) and their mutual spacing in the contact area with the conductor lines (2) is selected in such a manner that several fingers are placed simultaneously on one conductor line (2).

4. Probe head arrangement as claimed in any one of the preceding claims, characterized in that the fingers (4) have a rectangular cross-section, or a cross-section increasing toward the back (5).

5. Probe head arrangement as claimed in any one of the preceding claims, characterized in that the fingers (4) have a metallic coating.

6. Probe head arrangement as claimed in claim 1 or any one of claims 2 to 5, characterized in that autochecks for defects in the fingers, particularly shorts between adjacent fingers, or for contact with the conductor line to be contacted can be made.

7. Probe head arrangement as claimed in any one of the preceding claims, characterized in that several probe heads are arranged in a row one behind the other according to the contact pattern, in a spacing which corresponds to the shortest existing conductor line, or the spacing of the contact pads, or the maximum length on which defects are to be located.

8. Probe head arrangement as claimed in any one of the preceding claims, characterized in that for designing a tester one or several probe heads (1-32) are connected via one respective programmable, peripheral interface ($PPI_1$-$PPI_{32}$) to data (31), address (32), and control (33) buses of a microcomputer (30) which in turn can be connected to a computer (host computer 40) for carrying out and recording different tests.

9. Probe head arrangement as claimed in claim 7 or 8, characterized in that at the beginning of each test there is performed a correlation between the fingers (4) and the conductor lines (2) they contact (« find conductor line »), together with address determination.

10. Probe head arrangement as claimed in any one of the preceding claims, characterized in that as silicon monocrystalline silicon is used.

**Revendications**

1. Dispositif à palpeur destiné à être placé en contact avec une multiplicité de voies conductrices (2) étroites et situées côte-à-côte selon une disposition serrée ou d'organes de raccordement et pour déterminer des courts-circuits et des ruptures, et comportant au moins un palpeur (3) possédant une multiplicité de contacts élastiques (4), et dans lequel les contacts du palpeur (3) sont réalisés sous la forme de doigts d'un seul tenant (4), les doigts peuvent être apposés sur les voies conductrices (2) devant être contactées, obliquement par rapport au plan de ces voies conductrices (par leur axe longitudinal), et les doigts sont réalisés avec une largeur égale au maximum à la largeur des voies conductrices, sont alignés linéairement et sont maintenus assemblés sous la forme d'un peigne par l'intermédiaire d'un dos (5), caractérisé par le fait que :
   a) les doigts sont disposés sans aucune association fixe en vis-à-vis des voies conductrices,
   b) les doigts et le dos sont constitués en silicium, et
   c) le peigne constitué par les doigts et le dos est réalisé d'un seul tenant selon la technologie des semiconducteurs.

2. Dispositif à palpeur selon la revendication 1, caractérisé en ce que les circuits électroniques (6, 20), notamment des circuits logiques servant à réaliser l'amplification des signaux et l'adressage et réalisant un décodage, sont intégrés conjointement dans le palpeur (3) ou dans le dos (5) de ce dernier.

3. Dispositif à palpeur selon l'une des revendications précédentes, caractérisé en ce que la largeur (b) des doigts (4) et leur écartement réciproque dans la zone de contact avec les voies conductrices (2)

9

sont choisis de manière que plusieurs doigts soient simultanément en appui sur une voie conductrice (2).

4. Dispositif à palpeur selon l'une des revendications précédentes, caractérisé en ce que les doigts (4) possèdent une section rectangulaire ou qui augmente en direction du dos (5).

5. Dispositif à palpeur selon l'une des revendications précédentes, caractérisé en ce que les doigts (4) sont munis d'un revêtement métallique.

6. Dispositif à palpeur selon la revendication 1 ou l'une des revendications 2 à 5, caractérisé en ce qu'un contrôle automatique relatif à la présence de défauts dans les doigts, notamment la présence de courts-circuits entre des doigts voisins, ou relatif à l'établissement d'un contact avec la voie conductrice à contacter peut être exécuté.

7. Dispositif à palpeur selon l'une des revendications précédentes, caractérisé en ce que plusieurs palpeurs sont disposés côte-à-côte selon une rangée, conformément au modèle des contacts, à une distance réciproque qui correspond à la voie conductrice la plus courte présente ou à la distance des contacts de raccordement ou à la longueur maximale, sur laquelle des défauts doivent être localisés.

8. Dispositif à palpeur selon l'une des revendications précédentes, caractérisé en ce que pour réaliser un dispositif de contrôle, un ou plusieurs palpeurs (1-32) sont raccordés par l'intermédiaire d'interfaces périphériques programmables ($PPI_1$-$PPI_{32}$) à des bus (31) de transmision de données, (32) de transmission d'adresses et (33) de commande d'un micro-ordinateur (30), qui peut être relié pour sa part à un calculateur (ordinateur central 40) pour exécuter et établir le rapport de différents contrôles.

9. Dispositif à palpeur selon la revendication 7 ou 8, caractérisé en ce que au début de chaque essai, on réalise une association entre les doigts (4) et des voies conductrices (2) contactées par ces doigs (« détection de la voie conductrice ») avec une détermination d'adresses.

10. Dispositif à palpeur selon l'une des revendications précédentes, caractérisé en ce qu'on utilise, comme silicium, du silicium monocristallin.

FIG. 1

0 078 339

FIG. 2

FIG. 4

FIG. 3

FIG. 5 A

FIG. 5 B

FIG. 5 C

FIG. 5 D

FIG. 5 E

FIG. 7

2048 FINGER

STROM-QUELLE 22

ENABLE

FF$_C$

SET
RESET

BUS 1

SW1

EMPFÄN-GER 1    23    E1

SW2

SW3

BUS 2

EMPFÄN-GER 2    24    E2

20

FF 1    FF 2    FF 3    FF 4    FF 2047    FF 2048

DATA
STROBE
PRESET
RESET

1    2    3    4    2047    2048

ADR. 0
ADR. 10

ADRESSENKODIERUNG

21

HOST COMPUTER    40

FIG. 6

16 - BIT MICRO-COMPUTER    30

DAT.-BUS 31

CONTR. BUS 33

ADR. BUS 32

PPI 1    TAST-KOPF 1

PPI 2    TAST-KOPF 2

PPI 3    TAST-KOPF 3

PPI 32    TAST-KOPF 32

4